# EUROPEAN PATENT APPLICATION

(11) **EP 4 670 829 A2**
(43) Date of publication of application: **31.12.2025**
(21) Application number: 25216776.2
(22) Date of filing: 07.10.2019
(51) Int. Cl.: B01D 71/80

(54) **METHOD OF FILTERING LIQUIDS OR GASES FOR ELECTRONICS PRODUCTION**

(30) Priority: 05.10.2018 US 201862742077 P
(62) Divisional of application: 19868684.2
(71) Applicant: Terapore Technologies, Inc., South San Francisco, California 94080 (US)
(72) Inventor: DORIN, Rachel M., South San Francisco (US); ROBBINS, Spencer, South San Francisco (US)
(74) Representative: Appleyard Lees IP LLP

(57) **Abstract**

Methods of filtering a feed comprising a liquid or a gas for or during the production of electronics, nanosystems or ultrapure water include filtering said feed using at least one filter assembly, wherein said at least one filter assembly includes at least one isoporous block copolymer filtration membrane.

## Description

### Cross Reference to Related Application

This application claims the benefit of U.S. Provisional Application No. 62/742,077 filed October 5, 2019, the entire contents of which are incorporated herein by reference.

### Background of the Invention

As technology progresses in the microelectronics and semiconductor industries, the minimum feature size of the nodes is continually shrinking. Current technologies already represent sub-IO nm nodes such as 7 nm, and 5 nm node technology is already in development. As a consequence of these nanoscopic features, extremely stringent purity is required for the environment, water, chemicals, and gases that are involved in the production of various electronics. Even a handful of nanoscopic particulates or contaminants on a wafer is not suitable for many electronics applications.

To address the stringent purity requirements for the production of electronics, one of the most common approaches for purifying the environment, water, chemicals, and process gases, is filtration. Removing particulates with nanoscopic dimensions is quite challenging, and even more difficult when removing >99.9% of the nanoparticulates as required by the electronics industry. As the membrane pore size decreases, the more restrictive to flow it becomes, so it becomes more difficult to maintain high flow rates through the filter. In part, this is exacerbated by limitations of current filter technologies: current commercial technology does not generate membranes with uniform nanoscale pore sizes as well as high pore density, which would enable higher flow rates while maintaining very high nanoparticulate removal. Thus, one approach to improve the membrane flow rates are larger pore membranes which operate by depth filtration wherein particles get trapped in the thickness of the membrane at dead ends or small channels, rather than being excluded by an array of uniform pores which are smaller than the particulate. While these depth filters are widely used, they still include many pathways for small particles to pass through the filter, particularly once all the smaller paths have plugged with particles. Thus, these filters with pores larger than the particles targeted for removal are less effective at complete nanoparticulate exclusion necessitated by modern advanced electronics manufacturing.

### Brief Description of Drawings

FIG. I is a general schematic of a process in which air is filtered through an isoporous block copolymer filtration membrane, such as cleanroom air filtration or a process gas filtration.
FIG. 2 is a general schematic of a process in which a liquid is filtered through an isoporous block copolymer filtration membrane in a crossflow configuration. The filtration is driven by a pump and retentate is cycled back into the feed through a retentate outlet. The filter assembly also comprises a vent.
FIG. 3 is a general schematic of a process in which a liquid is filtered through an isoporous block copolymer filtration membrane in a normal flow configuration. The filtration is driven by a pump. The filter assembly also comprises a vent.
FIG. 4 is a general schematic of a process in which a liquid is filtered through an isoporous block copolymer filtration membrane in a normal flow configuration. The filtration is driven by compressed gas.
FIG. 5 is a general schematic of a process in which a liquid is filtered through an isoporous block copolymer filtration membrane in a normal flow configuration. The filtration is driven by a pump.
FIG. 6 is a schematic of a process in which a bulk volume of liquid is filtered through an isoporous block copolymer filtration membrane in a normal flow configuration into a storage vessel. The filtration is driven by compressed gas.
FIG. 7 is a schematic of a process in which a slurry is filtered through an isoporous block copolymer filtration membrane in a normal flow configuration for point of use in a chemical mechanical planarization step. The filtration is driven by a pump and dispenses the filtered slurry onto the rotating polishing pad which contacts the wafer which is rotated by a wafer holder.
FIG. 8 is a schematic of a process in which a liquid is filtered through an isoporous block copolymer filtration membrane in a normal flow configuration for point of use in a photolithography step. The filtration is driven by a pump and dispenses a spray of the filtered liquid onto the wafer.
FIG. 9 is a schematic of a process in which a bulk volume of water is filtered through an isoporous block copolymer filtration membrane in a normal flow configuration into a storage vessel, for ultrapure water. The filtration is driven by a pressurized water source and the storage vessel feeds multiple faucets/dispensers.
FIG. 10 is a schematic of a process in which water is filtered through an isoporous block copolymer filtration membrane in a normal flow configuration for point of use ultrapure water. The filtration is driven by a pressurized water source and the filtered ultrapure water feeds a faucet/dispenser.
FIG. 11 is a schematic of a process in which a liquid is filtered through an isoporous block copolymer filtration membrane in a normal flow configuration for point of use in a wet etch and clean step. The filtration is driven by a compressed gas and dispenses the filtered liquid into the liquid bath.
FIG. 12 is a schematic of a process in which a liquid is filtered through an isoporous block copolymer filtration membrane in a normal flow configuration for point of use in a wet etch and clean step. The filtration is driven by a pump and dispenses the filtered liquid into the liquid bath. The process further comprises a drain to the liquid bath which feeds a pump which can drive the bath liquid through a second isoporous block copolymer filter and feed back into the bath through a bath recirculation fill.
FIG. 13 is a schematic of a process in which a liquid is filtered through an isoporous block copolymer filtration membrane in a normal flow configuration for point of use in a wet etch and clean step. The filtration is driven by a pump and dispenses the filtered liquid into the liquid bath.
FIG. 14 is a schematic of a process in which a gas is filtered through an isoporous block copolymer filtration membrane in a normal flow configuration into a storage vessel. The filtration is driven by a compressed gas cylinder and the filtered gas is collected/stored in a storage vessel which feeds multiple outlet valves.

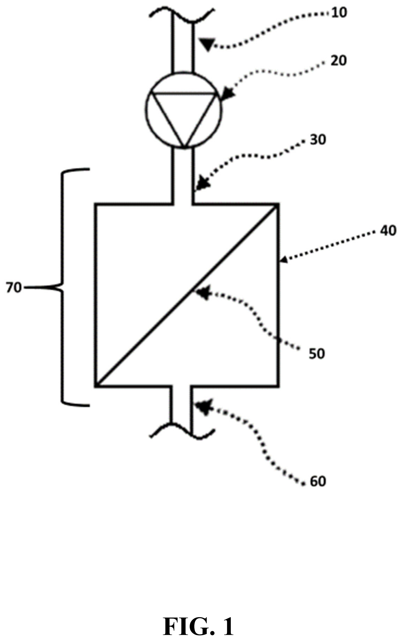

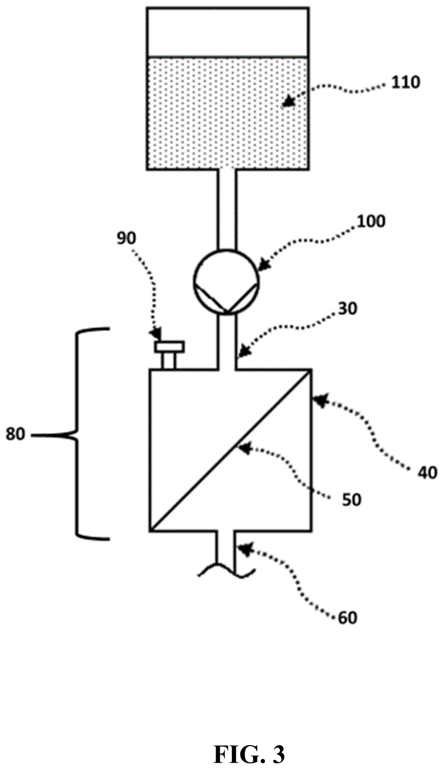

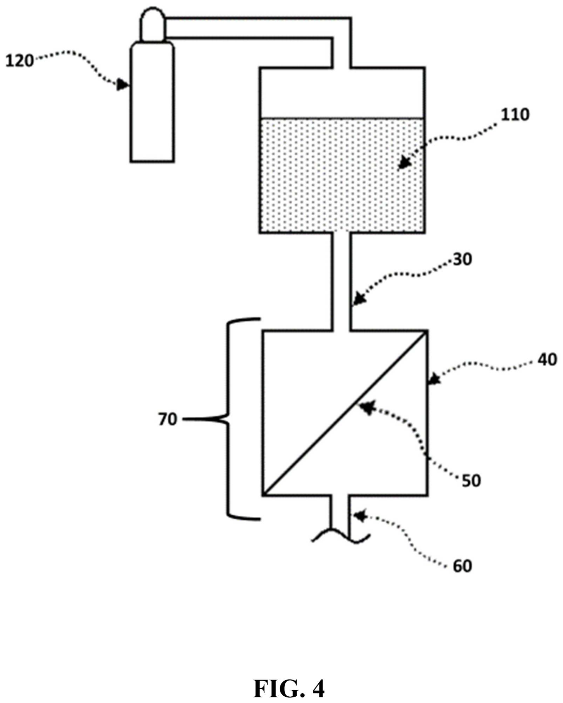

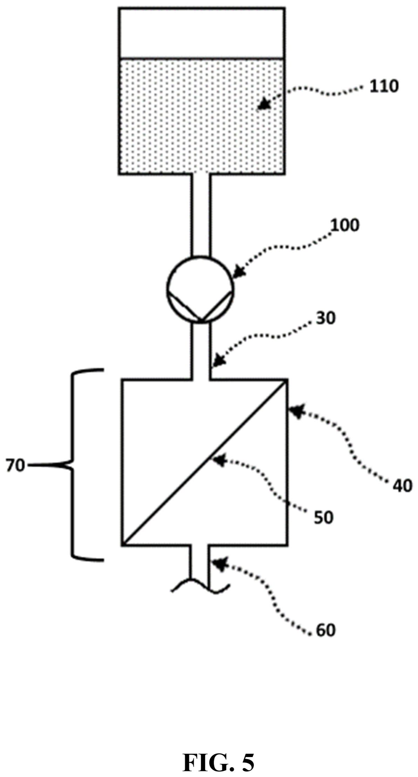

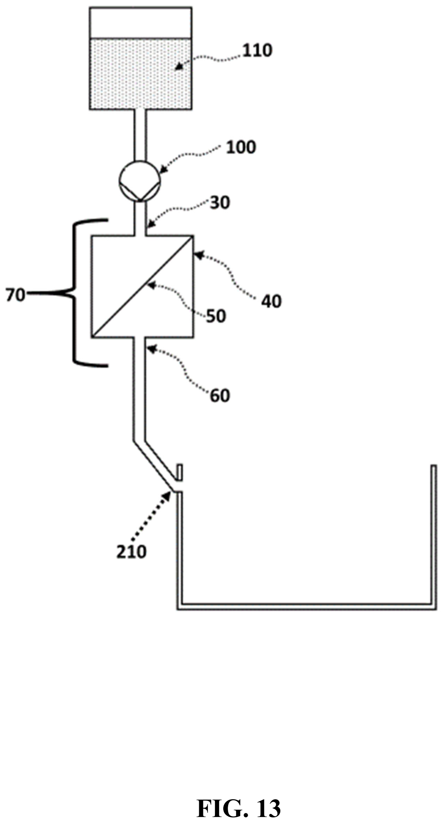

Each of FIGS. 1-14 show one or more the following elements: an air source 10, a fan 20, a filter assembly inlet 30, a filter assembly housing 40, an isoporous block copolymer film 50, a filter outlet 60, a filter assembly 70, a filter assembly retentate outlet 80, a filter assembly vent 90, a pump 100, a liquid feed source 110, a compressed gas cylinder 120, a collection/storage vessel 130, a slurry feed 135, a slurry dispensing outlet 140, a rotating wafer holder 150, a wafer 160, a rotating polishing pad 170, a liquid sprayer outlet 180, a pressurized water feed 190, a faucet/dispenser 200, a bath fill 210, a liquid bath 220, a bath drain 230, a bath recirculation fill 240, and an outlet valve 250.

### Detailed Description

The following description of the embodiments is merely exemplary in nature and is in no way intended to limit the subject matter of the present disclosure, their application, or uses.

As used throughout, ranges are used as shorthand for describing each and every value that is within the range. Any value within the range can be selected as the terminus of the range.

For the purposes of this specification and appended claims, unless otherwise indicated, all numbers expressing quantities, percentages or proportions, and other numerical values used in the specification and claims, are to be understood as being modified in all instances by the term "about." The use of the term "about" applies to all numeric values, whether or not explicitly indicated. This term generally refers to a range of numbers that one of ordinary skill in the art would consider as a reasonable amount of deviation to the recited numeric values (i.e., having the equivalent function or result). For example, this term can be construed as including a deviation of ±IO percent, alternatively ±5 percent, and alternatively ±I percent of the given numeric value provided such a deviation does not alter the end function or result of the value. Accordingly, unless indicated to the contrary, the numerical parameters set forth in this specification and attached claims are approximations that can vary depending upon the desired properties sought to be obtained by the present invention.

It is noted that, as used in this specification and the appended claims, the singular forms "a," "an," and "the," include plural references unless expressly and unequivocally limited to one referent. As used herein, the term "include" and its grammatical variants are intended to be nonlimiting, such that recitation of items in a list is not to the exclusion of other like items that can be substituted or added to the listed items. For example, as used in this specification and the following claims, the terms "comprise" (as well as forms, derivatives, or variations thereof, such as "comprising" and "comprises"), "include" (as well as forms, derivatives, or variations thereof, such as "including" and "includes") and "has" (as well as forms, derivatives, or variations thereof, such as "having" and "have") are inclusive (i.e., open-ended) and do not exclude additional elements or steps. Accordingly, these terms are intended to not only cover the recited element(s) or step(s), but may also include other elements or steps not expressly recited. Furthermore, as used herein, the use of the terms "a" or "an" when used in conjunction with an element may mean "one," but it is also consistent with the meaning of "one or more," "at least one," and "one or more than one." Therefore, an element preceded by "a" or "an" does not, without more constraints, preclude the existence of additional identical elements.

The present disclosure relates to water, chemical, or gas filtration processes in the production of electronics or nanosystems using at least one isoporous block copolymer filtration membrane. In the context of the present disclosure, "isoporous" means having a substantially narrow pore diameter distribution. Electronics manufacturing includes production of, for example, microelectronics, semiconductor electronics, electronic displays, flexible electronics, quantum electronics, integrated circuits, lithography. Nanosystems include microfluidics, nanoparticle production.

For example, the inventors have found that newer filter technology, isoporous block copolymer films such as those disclosed in US9527041B2, incorporated herein by reference, can be used for water, chemical, or gas filtration processes in the production of electronics or nanosystems. These block copolymer films are one solution to the challenging filtrations required by current electronics manufacturers. Block copolymers are polymers comprising two or more distinct "blocks" which differ with respect to their chemistries. Block copolymers can be processed into filtration membrane, wherein the polymers self-assemble with a selective layer including 5-100 nm diameter pores. The self-assembly process enables highly uniform pore sizes with high pore densities, on the nanoscale. The highly uniform nanopores can completely reject nanoparticulates that are smaller than the pores, and the high pore density allows high flow rates despite the extremely small pores. No conventional filter technology is able to achieve the combination of filter resolution and flow rates compared to these isoporous block copolymer filtration membranes. Isoporous block copolymer filtration membranes will enable extremely high purity environments, chemicals, water, and gases necessary for current and future production of advanced electronics.

The isoporous block copolymer filtration membranes used in the inventive processes of the present disclosure comprise mesopores and these mesopores have diameters of about 5 nm to about I 00 nm. In at least one embodiment the mesopore diameters are in the range of about 5 nm to about I 00 nm. In at least one embodiment the mesopore diameters are in the range of about 5 nm to about 75 nm. In at least one embodiment the mesopore diameters are in the range of about 5 nm to about 50 nm. In at least one embodiment the mesopore diameters are in the range of about I 0 nm to about I 00 nm. In at least one embodiment the mesopore diameters are in the range of about 10 nm to about 75 nm. In at least one embodiment the mesopore diameters are in the range of about IO nm to about 50 nm. It is noted that the mesopores are typically the most selective pores in the isoporous block copolymer filtration membranes and the mesopore diameters largely determine the rejection characteristics of a given solute. For example, a mesopore diameter around 20 nm will tend to reject solutes and particulates around 20 nm and up.

Block copolymers may comprise multiple distinct chemistries m different sections, referred to as "blocks". In the context of isoporous block copolymer filtration membranes, blocks and their relative positions in the polymer may be engineered to impart a desired functionality in the filtration membrane. For example, the block copolymer size, composition, and topology of isoporous block copolymer filtration membranes can all be engineered to impart distinctive characteristics of the final filtration membrane and filter assembly in which the membrane is incorporated. Furthermore, the conditions of the production of the filtration membranes affect the membrane properties, including parameters such as casting solution concentration, casting solution composition, evaporation time, relative humidity, and coagulation bath composition and temperature. Consequently, the filtration membranes can be engineered through a combination of block copolymer composition and processing conditions to have, for example, specific pore diameters, specific surface and/or interior chemistries. This versatility allows for control of filtration membrane properties and functionality, and appropriate filters can be generated for a given application. For example, an isoporous block copolymer filtration membrane can be produced wherein the surface chemistry is chemically resistant, allowing for use in harsh environments such as strong organic solvents, acids or bases commonly used in electronics manufacturing. Furthermore, alone or in combination with another functionality, isoporous block copolymer filtration membranes may be engineered to include thermally stable polymer chemistry to enable high temperature stability, allowing for filtration at elevated temperatures, as is also commonly used in electronics production. Due to their multiple block chemistries, more than one functionality can be engineered into the same isoporous block copolymer filtration membrane. For example, a chemically and thermally resistant membrane.

In some embodiments, an isoporous block copolymer filtration membrane comprising multiple functionalities is used to filter gas or liquid in the production of electronics. Furthermore, functionality or functionalities may be imparted on the isoporous block copolymer filtration membranes after they have been formed. For example, a chemical reaction after the filtration membrane has been formed may impart chemical resistance, or antifouling character on the membrane surface or bulk. Another example is a physical deposition of a functional conformal coating on the membrane after it has been formed. Any specific functionalities may be engineered or tuned by extent of reaction or coating, which may be controlled, for example, by the amount of reagent or temperature. The varying functionalities enable isoporous block copolymers to be integrated into the various filtrations necessary for liquids and gases in the production of electronics. For example, isoporous block copolymer filtration membranes for aqueous separations are likely to be hydrophilic to facilitate filtering of an aqueous feedstream; isoporous block copolymer filtration membranes for hydrophobic solvent feedstreams are likely to be hydrophobic and solvent-stable to facilitate the filtration; isoporous block copolymer filtration membranes for high temperature liquids are likely to be high temperature stable to facilitate the filtration.

A variety of multiblock copolymers can be used for the fabrication of isoporous block copolymer filtration membranes. For example, the multiblock copolymer can be a diblock copolymer, triblock copolymer, or higher order multiblock copolymer. In various embodiments, the multiblock copolymer is a triblock terpolymer having a structure of the form A-B-C, or A-C- B, or other variable arrangements or containing blocks of different chemical composition. In other embodiments, additional structures are higher order multi-block copolymer systems of the form A-B-C-B, or A-B-C-D, or A-B-C-B-A, or A-B-C-D-E, or other variable arrangements of these higher order systems. The multiblock copolymers can be synthesized by methods known in the art. For example, the copolymers can be synthesized using anionic polymerization, atom transfer radical polymerization (ATRP), or other suitable polymerization techniques. The multiblock copolymers can be also be obtained commercially.

The polymer blocks can have a broad molecular weight range. For example, blocks having a number averaged molecular weight (Mn) of from Ix I 0³ to Ix I 0⁶ g/mol, including all values to the IO g/mol and ranges therebetween.

In some instances, the multiblock copolymer can have at least one hydrogen-bonding block. The hydrogen-bonding block can self-assemble with another structurally distinct polymer block of the multiblock copolymer (e.g., a hydrophobic block). The hydrogen-bonding block has an acceptor group or donor group that can participate in intramolecular hydrogen bonding. The hydrogen-bonding block can be a hydrophilic block. Examples of suitable hydrogen-bonding blocks include poly((4-vinyl)pyridine), poly((2-vinyl) pyridine), poly(ethylene oxide), poly(methacrylates) such as poly(methacrylate), poly(methyl methacrylate), and poly(dimethylethyl amino ethyl methacrylate), poly(acrylic acid), and poly(hydroxystyrene). In an embodiment, the hydrophilic block is poly((4-vinyl)pyridine).

The multiblock copolymer will generally one or more blocks that are hydrophobic blocks. The hydrophobic blocks form the matrix of the resulting isoporous block copolymer filtration membrane. For example, the multiblock copolymer can have one or two hydrophobic blocks in addition to the hydrogen-bonding block(s). Examples of suitable hydrophobic blocks include poly(styrenes) such as poly(styrene) and poly(alpha-methyl styrene), polyethylene, polypropylene, polyvinyl chloride, and polytetrafluoroethylene.

In some embodiments, at least one of the additional hydrophobic blocks is a low glass transition temperature (Tg) block. By low Tg block it is meant that the block has a Tg of 25° C. or less. The multiblock copolymer can have multiple low Tg blocks. Examples of suitable low Tg blocks include poly(isoprene), poly(butadiene), poly(butylene), and poly(isobutylene). In an embodiment, the multiblock copolymer comprises a low Tg polymer block, a poly(styrene) block, and a poly((4-vinyl) pyridine) block.

Examples of suitable diblock copolymers for the fabrication of isoporous block copolymer filtration membranes include b-poly(styrene)-b-poly((4-vinyl)pyridine), poly(styrene)-b-poly((2-vinyl) pyridine), poly(styrene)-b-poly(ethylene oxide), poly(styrene)-b-poly(methyl methacrylate), poly(styrene)-b-poly(acrylic acid), poly(styrene)-b-poly(dimethylethyl amino ethyl methacrylate), poly(styrene)-b-poly(hydroxystyrene), poly(α-methyl styrene)-b-poly((4-vinyl)pyridine), poly(α-methyl styrene)-b-poly((2-vinyl) pyridine), poly(α-methyl styrene)-b-poly(ethylene oxide), poly(α-methyl styrene)-b-poly(methyl methacrylate), poly(α-methyl styrene)-b-poly(acrylic acid), poly(α-methyl styrene)-b-poly(dimethylethyl amino ethyl methacrylate), poly(α-methyl styrene)-b-poly(hydroxystyrene), poly(isoprene)-b-poly((4-vinyl)pyridine), poly(isoprene)-b-poly((2-vinyl) pyridine), poly(isoprene)-b-poly(ethylene oxide), poly(isoprene)-b-poly(methyl methacrylate), poly(isoprene)-b-poly(acrylic acid), poly(isoprene)-b-poly(dimethylethyl amino ethyl methacrylate), poly(isoprene)-b-poly(hydroxystyrene), poly(butadiene)-b-poly((4-vinyl)pyridine), poly(butadiene)-b-poly((2 -vinyl) pyridine), poly(butadiene)-b-poly(ethylene oxide), poly(butadiene)-b-poly(methyl methacrylate), poly(butadiene)-b-poly(acrylic acid), poly(butadiene)-b-poly(dimethylethyl amino ethyl methacrylate), and poly(butadiene)-b-poly(hydroxystyrene).

Examples of suitable triblock copolymers for the fabrication of isoporous block copolymer filtration membranes include poly(isoprene-b-styrene-b-4-vinylpyridine), poly(isoprene)-b-poly(styrene)-b-poly((4-vinyl)pyridine), poly(isoprene)-b-poly(styrene)-b-poly((2-vinyl) pyridine), poly(isoprene)-b-poly(styrene)-b-poly(ethylene oxide), poly(isoprene)-b-poly(styrene)-b-poly(methyl methacrylate), poly(isoprene )-b-poly(styrene)-b-poly(acrylic acid), poly(isoprene)-b-poly(styrene)-b-poly(dimethyl ethyl amino ethyl methacrylate), poly(isoprene)-b-poly(styrene)-b-poly(hydroxystyrene), poly(isoprene)-b-poly(α-methyl styrene)-b-poly((4-vinyl)pyridine), poly(isoprene)-b-poly(α-methyl styrene)-b-poly((2-vinyl) pyridine), poly(isoprene)-b-poly(a-methyl styrene)-b-poly(ethylene oxide), poly(isoprene)-b-poly(α-methyl styrene)-b-poly(methyl methacrylate), poly(isoprene)-b-poly(α-methyl styrene)-b-poly(acrylic acid), poly(isoprene)-b-poly(α-methyl styrene)-b-poly(dimethyl ethyl amino ethyl methacrylate), poly(butadiene)-b-poly(styrene)-b-poly((4-vinyl)pyridine), poly(butadiene)-b-poly(styrene)-b-poly((2-vinyl) pyridine), poly(butadiene)-b-poly(styrene)-b-poly(ethylene oxide), poly(butadiene)-b- poly(styrene)-b-poly(methyl methacrylate), poly(butadiene)-b-poly(styrene)-b-poly(acrylic acid), poly(butadiene)-b-poly(styrene)-b-poly(dimethylethyl ammo ethyl methacrylate), poly(butadiene)-b-poly(styrene)-b-poly(hydroxystyrene), poly(butadiene)-b-poly(α-methyl styrene)-b-poly((4-vinyl)pyridine), poly(butadiene)-b-poly(α-methyl styrene)-b-poly((2-vinyl)pyridine), poly(butadiene)-b-poly(α-methyl styrene)-b-poly(ethylene oxide), poly(butadiene)-b-poly(α-methyl styrene)-b-poly(methyl methacrylate), poly(butadiene)-b-poly(α-methyl styrene)-b-poly(acrylic acid), poly(butadiene)-b-poly(α-methyl styrene)-b-poly(dimethylethyl amino ethyl methacrylate), and poly(butadiene)-b-poly(styrene)-b-poly(hydroxystyrene).

The total molar mass of multi-block copolymers can be such that the multiblock copolymer undergoes self-assembly (i.e., microphase separation). It is desirable that defect-free surfaces are formed upon meso- and macro-porous structure formation. For example, the total molar mass of the multiblock copolymer is from 5 x I 0³ to 5 x I 0⁵ g/mol, including all values to the IO g/mol and ranges therebetween.

Multiblock copolymers can have a range of polydispersities (Mw/Mn). For example, the multiblock copolymers can have a polydispersity index (PDI) of from 1.0 to 2.0, including all values to the 0.1 and ranges therebetween. In some cases, it is desirable that the multiblock copolymer have a PDI of 1 to 1.4.

The isoporous block copolymer filtration membranes can have a variety of shapes. The filtration membranes can also have a broad range of sizes (e.g., film thicknesses and film area). For example, the filters can have a thickness of from 5 microns to 500 microns, including all values to the micron and ranges therebetween. Depending on the application, the filters can have areas ranging from tens of cm² to tens (even hundreds) of m².

The isoporous block copolymer filtration membranes can have desirable properties. For example, the filtration membranes can have desirable mechanical properties (e.g., toughness) and permeability. The mechanical properties of the filtration membranes can be tailored by use of selected multiblock copolymers. For example, filtration membrane toughness can be improved by using a low T_{g} poly(isoprene) block in the multiblock copolymer.

The structural and performance characteristics of the filtration membranes can include both stimuli responsive permeation and separation. The structure of copolymers can be modified such that the filter formed therefrom can allow for logical control and transport of various liquids, solids and gases. For example, the pore size of the filtration membranes can be tuned (e.g., increased or decreased) by hybridization of the membrane by incorporating a homopolymer or a small molecule in the deposition solution or by exposing the membrane to a specific pH solution (e.g., the filter is exposed a feed solution having a desired pH).

In some instances, isoporous block copolymer filtration membranes according to the present disclosure can have a surface layer and a bulk layer. The surface layer can have a range of thicknesses. For example, the surface layer can have a thickness of from 20 nm to 500 nm, including all values to the nm and ranges therebetween. The surface layer can have a plurality of pores extending thorough the depth of the surface layer. The pores can have various morphologies, such as cylindrical and gyroid morphologies. The pores can have a size (e.g., diameter) of from 5 nm to 100 nm, including all values to the nm and ranges therebetween. The surface layer can have a range of pore densities. For example, the surface layer pore density can be from 1x10¹⁴ pores/m² to 1x10¹⁵ pores/m², including all values to the 10 pores/m² and ranges therebetween. In some instances, the density of the surface pores of a membrane as described herein is at least 10¹⁴ pores/m². The surface layer can be isoporous. By "isoporous" it is meant that the pores have narrow pore size distribution. For example, a narrow pore size distribution (defined as the ratio of the maximum pore diameter to the minimum pore diameter (dmaxldmin)) can be from 1 to 3, including all values to 0.1 and ranges therebetween. In various examples, (dmaxldmin) is 1, 1.5, 2, 2.5, or 3. For example, the film comprises a surface layer having vertically aligned and nearly monodisperse mesopores. In an embodiment, the isoporous surface layer has a pore density of at least 1x10¹⁴ pores/m² and a pore size distribution (dmaxldmin) of less than 3.

The bulk layer can be a supporting sub-structure layer. The bulk layer can have a range of thicknesses. For example, the thickness of the bulk layer can be from 5 microns to 500 microns, including all values to the micron and ranges therebetween. The pores in the bulk layer can be from 10 nm to 100 microns in size (e.g., diameter), including all values to the nm and ranges therebetween. The bulk layer can have an asymmetric structure. For example, the bulk layer can have a sponge-like or finger-like structure. Moving from the top of this layer (e.g., the surface in contact with the surface layer) to the bottom of the layer (e.g., the free surface or surface in contact with the substrate), the pores increase in size. For example, the bulk layer can have pores having a size of 10 nm at the top of the bulk layer (layer in contact with the surface layer) and the pores increase in size to 100 µm at the bottom of the bulk layer. The increase in pore size moving though the depth of the membrane (e.g., from the surface of the bulk film in contact with the surface layer to the surface of the bulk layer opposite the surface layer) provides an asymmetric structure. This bulk layer can be formed as a result of contacting (e.g., immersing) the block copolymer into a non-solvent bath (e.g., a NIPS process).

In some instances, the isoporous block copolymer membranes according to the present disclosure can be hybrid membranes. A hybrid membrane can further comprise a homopolymer or small molecule additive. The homopolymer or small molecule is blended in the block copolymer prior to fabrication of the filtration membrane. The homopolymer or small molecule can be blended in (i.e., mixed with) a hydrogen-bonding block or hydrophobic block of the multiblock copolymer. The homopolymer or small molecule preferentially associates with one of the blocks of the block copolymer and locates in the vicinity of that block. For example, poly(phenylene oxide) can mix with a poly(styrene) block of a block copolymer. For example, poly(butadiene) can mix with a poly(isoprene) block of a block copolymer.

Any homopolymer that has the same chemical composition as or can hydrogen bond to at least one block (e.g., the hydrogen-bonding block) of the block copolymer can be used. The homopolymer can have hydrogen bond donors or hydrogen bond acceptors. Examples of suitable homopolymers include poly((4-vinyl)pyridine), poly(acrylic acid), and poly(hydroxy styrene). It is desirable that the homopolymers or small molecules have a low or negative chi parameter with the hydrogen-bonding block (e.g., poly((4-vinyl)pyridine)). A range of ratios of block copolymer to homopolymer can be used. For example, the molar ratio of block copolymer to homopolymer can be from I:0.05 to I:10, including all ranges therebetween. The homopolymer can have a range of molecular weight. For example, the homopolymer can have a molecular weight of from 5 x I 0² g/mol to 5 x I 0⁴ g/mol.

Any small molecule that can hydrogen bond to at least one block of the block copolymer can be used. The small molecule can have hydrogen bond donors or hydrogen bond acceptors. Examples of suitable small molecules include pentadecyl phenol, dodecyl phenol, 2-4'-(hydroxybenzeneazo)benzoic acid (HABA). 1,8-naphthalene-dimethanol, 3-hydroxy-2-naphthoic acid, and 6-hydroxy-2-naphthoic acid. A range of ratios of block copolymer to small molecule can be used. For example, the molar ratio of block copolymer to small molecule can be from 1: 1 to 1: 1 000, including all integer ratios therebetween.

In some instances, the film further comprises an inorganic material. The inorganic material is disposed on at least a portion of the film (e.g., the top, self-assembled surface layer surface, pore surface of the surface layer, and pore surface of the graded substructure). For example, the inorganic material can be in the form of nanoparticles. The nanoparticles can be, for example, 1 to 200 nm, including all values to the nanometer and ranges therebetween, in diameter. Examples of suitable inorganic materials include metals, metal oxides (e.g., silver oxide and copper oxide) and semiconductors (e.g., semiconducting nanoparticles such as CdS nanoparticles). For example, the inorganic material can be disposed on at least 50%, at least 60%, at least 70%, at least 80%, at least 90%, at least 95%, at least 99% of the surfaces of the film. In an example, the inorganic material is disposed on I00% of the surfaces of the film.

For example, the film further comprises a plurality of metal nanoparticles. The metal nanoparticles inorganic are disposed on at least a portion of the film (e.g., the top, self-assembled surface layer surface, pore surface of the surface layer, and pore surface of the graded substructure). The nanoparticles can complex (e.g., through weak intramolecular forces) with the multiblock copolymer of the film surface. The nanoparticles can be, for example, 1 to 200 nm, including all values to the nanometer and ranges therebetween, in diameter. Examples of suitable metals for the metal nanoparticles include gold, silver, platinum, palladium, cobalt, copper, nickel, iron, zinc, chromium, ruthenium, titanium, zirconium, molybdenum, aluminum, and cadmium. The nanoparticles can be mixtures of different nanoparticles. For example, the metal nanoparticles can be disposed on at least 50%, at least 60%, at least 70%, at least 80%, at least 90%, at least 95%, at least 99% of the surfaces of the film. In an example, the metal nanoparticles are disposed on 100% of the surfaces of the film. Films with silver nanoparticles can exhibit antimicrobial behavior.

The inorganic materials can be deposited on the film by methods known in the art. For example, the inorganic material can be deposited by electroless deposition methods.

In some embodiments, isoporous block copolymer filtration membranes according to the present disclosure are used to filter out particles or particulates from a liquid or gas feed. The particles or particulates to be removed are generally undesirable contaminants that could negatively influence the properties of a process or product. The particles or particulates could be for example: nanoparticles, insoluble salts, dirt, dust, fibers, polymeric particles, resin particles, metal ions, bacteria, or viruses. One or more appropriate isoporous block copolymer filtration membranes may be selected for a particular application depending on potential contaminants' properties such as size and chemistry, as well as feed properties such as composition, temperature, and concentration.

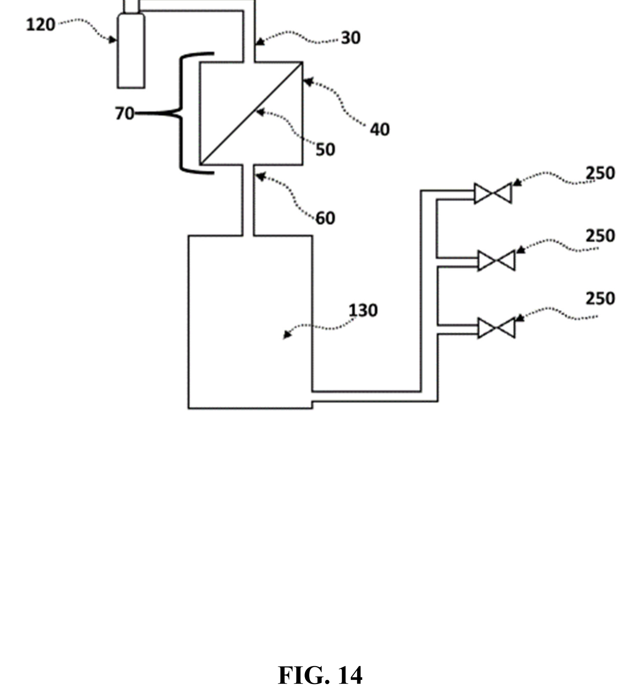

In some embodiments, at least one gas for use in electronics production is filtered through at least one isoporous block copolymer filtration membrane (FIGS. 1 and 14). For example, the gas that can be filtered is inert, such as nitrogen, argon or krypton. Other examples include filtering a gas that is hazardous, reactive, or corrosive, such as chlorine, ethylene oxide, silane, hydrogen chloride, hydrogen fluoride, or hydrogen sulfide. The filtration membranes and filter assemblies in which the membranes are incorporated could be used to filter air, as in cleanroom air purification. In at least one embodiment, the gas that is filtered is a process gas during the electronics production, such as silane or hydrogen fluoride.

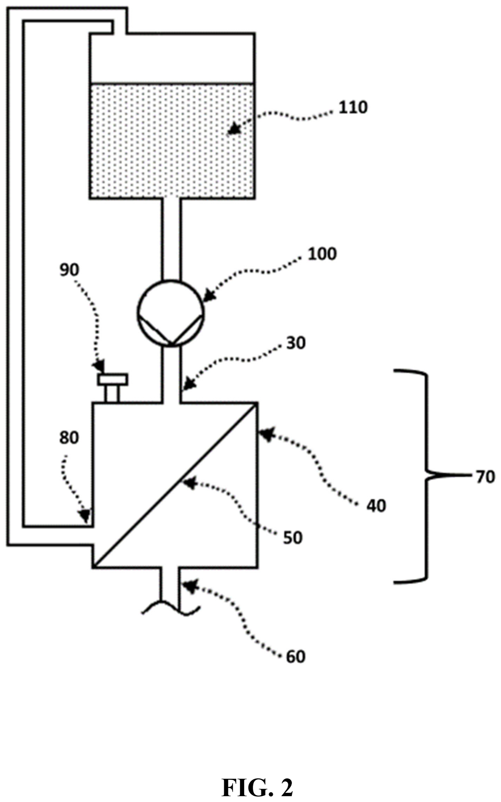

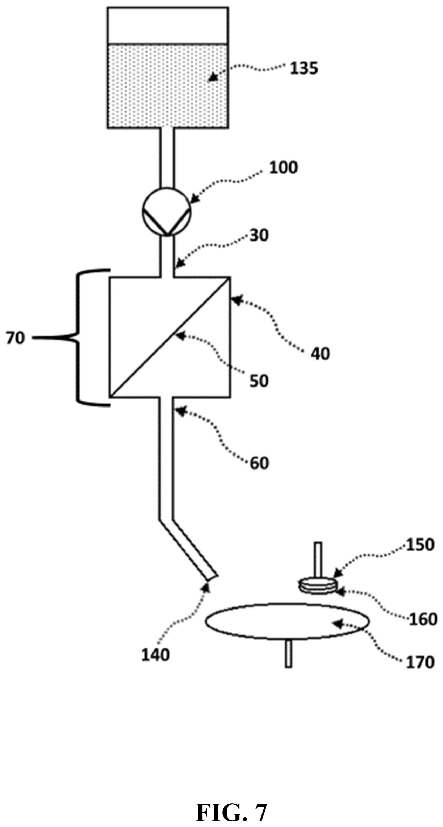

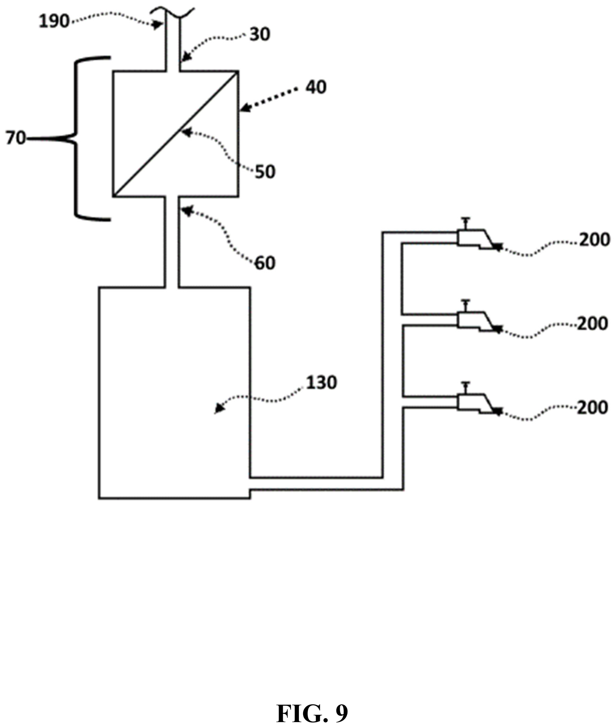

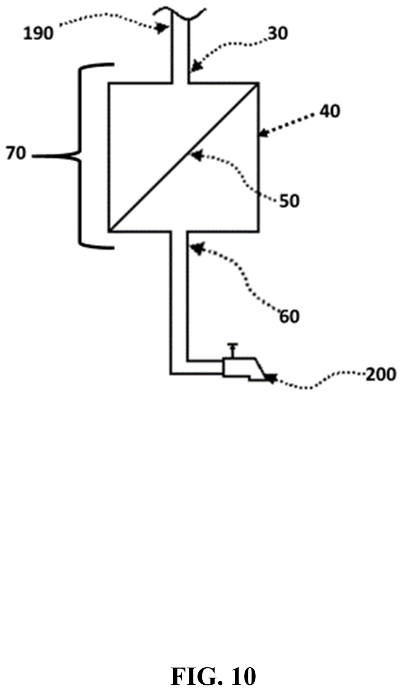

In some embodiments, at least one liquid for use in electronics production is filtered through at least one isoporous block copolymer filtration membrane (FIGS. 2 - 6, 8 - 13). For example, in some instances the liquid that is filtered is aqueous, i.e. comprising water. In some embodiments, the liquid that is filtered is aqueous and used in the production or recycling of ultrapure water (UPW) (FIGS. 9 and 10). Other examples would include an aqueous feed comprising an acid, such as hydrochloric acid or hydrofluoric acid. In another example, the aqueous feed further comprises a base, such as sodium hydroxide or potassium hydroxide. The feed could include inorganic or organic chemicals. In at least one embodiment, the feed is a slurry (FIG. 7).

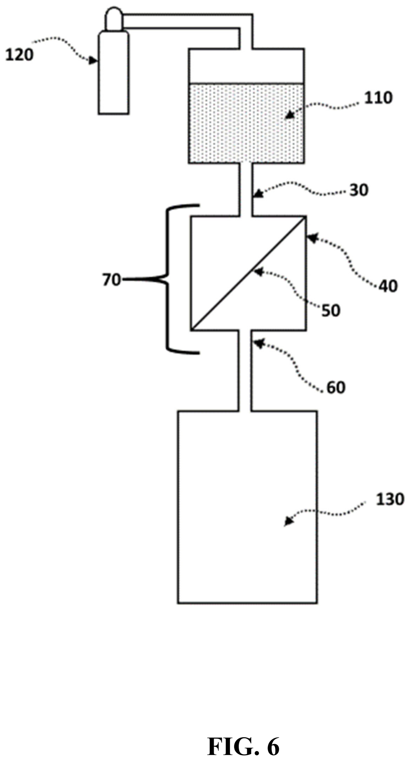

In at least one embodiment, water, gas, or liquid chemicals are filtered through an isoporous block copolymer filtration membrane in bulk (FIGS. 6 and 9). For example, 100 gallons of a chemical in a storage tank is filtered through an isoporous block copolymer filtration membrane and stored in another storage tank until ready for use. The isoporous block copolymer filtration membrane can be used to bulk filter a liquid, wherein the liquid is aqueous or nonaqueous. In at least one embodiment, the isoporous block copolymer filtration membrane is used to bulk filter a liquid, wherein the liquid comprises both aqueous and nonaqueous constituent liquids. In at least one embodiment, the isoporous block copolymer filtration membrane is used to bulk filter a gas or gases.

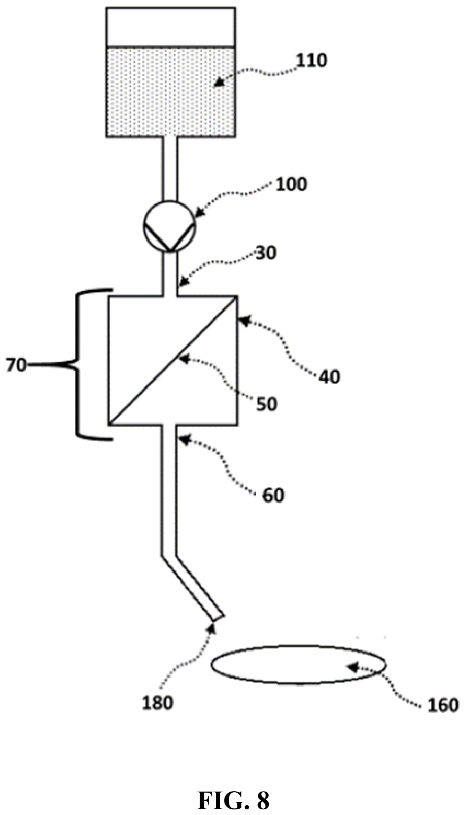

In at least one embodiment, the filtration is performed as point of use (FIGS. 8 and 10 - 13). For example, an etchant chemical is filtered through an isoporous block copolymer filtration membrane immediately before it is dispensed on a wafer. For example, a photoresist removal solvent could be filtered before it is sprayed on a wafer. In addition, the components of the photoresist removal solvent could be filtered during the process of making the photoresist removal solvent that is ultimately used during the wafer processing step.

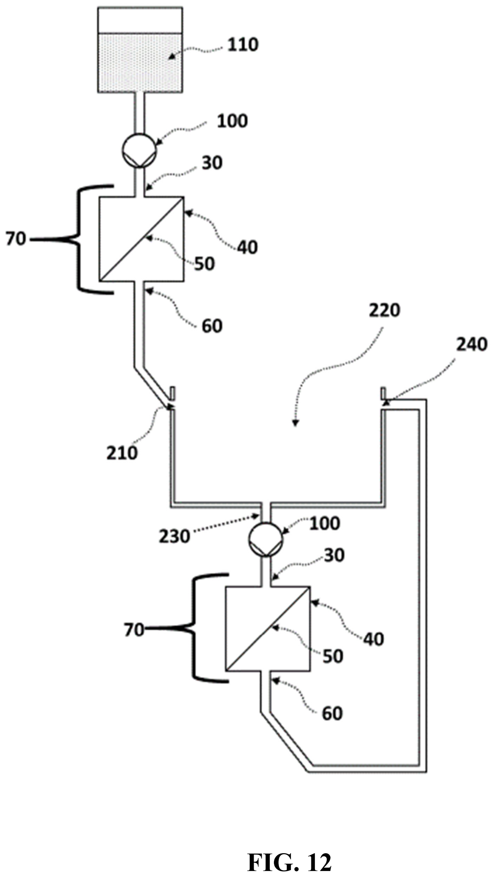

In at least one embodiment, the filtration is performed in a recycling step (FIG. 12). For example, a photoresist removal solvent is sprayed on a wafer, and the excess solvent is collected and is filtered through an isoporous block copolymer filtration membrane such that the solvent may be reused.

In at least one embodiment, the filtration is performed as part of the facilities of an electronics producer. For example, the filtration could be performed on air as part of cleanroom air filters. Another example is filtration of water for ultrapure water for use in a facility in electronics production.

In some embodiments, the isoporous block copolymer filtration membrane is housed within a filter assembly comprising an inlet, an outlet, optionally a vent, and optionally a retentate outlet (FIGS. 1 - 14). In at least one embodiment, the filter assembly comprises one layer of an isoporous block copolymer filtration membrane. In at least one embodiment, the filter assembly comprises two layers of an isoporous block copolymer filtration membrane, wherein the two membrane layers are made of the same or different block copolymers. In at least one embodiment, the filter assembly comprises three layers of an isoporous block copolymer filtration membrane, wherein the three membrane layers are made of the same or different block copolymers. In some embodiments, when there is more than one layer of an isoporous block copolymer filtration membrane, the layers are oriented with the most selective side facing the same direction. In some embodiments, when there is more than one layer of an isoporous block copolymer filtration membrane, the layers are oriented with the most selective side facing in different directions. In some embodiments, when there is more than one layer of an isoporous block copolymer filtration membrane, the different filter layers may be the same type of material, for example, isoporous block copolymers having the same pore diameters, chemical compositions, etc. In some embodiments, when there is more than one layer of an isoporous block copolymer filtration membrane, the different filter layers may be different types of material, for example, isoporous block copolymers having different pore diameters, chemical compositions, etc.

In some embodiments, isoporous block copolymer filtration membranes according to the present disclosure are operated in a normal flow, also known as dead end, configuration wherein a feed liquid or gas is exposed to the filter inlet, then filtered, and then exits through the filter outlet (FIGS. 1 and 3 - 14).

In some embodiments, isoporous block copolymer filtration membranes according to the present disclosure are operated in a crossflow, also known as tangential flow, configuration wherein a feed liquid or gas is exposed to a filter inlet, flows tangential to the filter surface, what is filtered exits through a filter outlet and the unfiltered feed passes out a retentate outlet and is cycled back into the feed or feed reservoir (FIG. 2).

Isoporous block copolymer filtration membranes according to the present disclosure may be used in various configurations. For example, the isoporous block copolymer filtration membranes can be used in a flat sheet configuration, a hollow fiber configuration, a spiral wound configuration, a crossflow cassette, or a pleated cartridge configuration. In some embodiments, the housing is, for example, a plastic capsule or a point of use housing. In some embodiments, more than one configuration may be used.

In some embodiments, isoporous block copolymer filtration membranes according to the present disclosure can be used for filtration at ambient temperature, around 20-25 °C.

In some embodiments, the isoporous block copolymer filtration membranes can be used for filtration at elevated temperatures, higher than 20-25 °C. In at least one embodiment, the elevated temperature is in the range of about 30 °C to about 200 °C. In at least one embodiment, the elevated temperature is in the range of about 50 °C to about 200 °C. In at least one embodiment, the elevated temperature is in the range of about 70 °C to about 200 °C.

In some embodiments, the isoporous block copolymer filtration membranes can be used for filtration at a temperature lower than 20-25 °C. In at least one embodiment, the lower temperature is in the range of about 0 °C to about 20 °C. In at least one embodiment, the lower temperature is in the range of about 5 °C to about 20 °C. In at least one embodiment, the lower temperature is in the range of about 10 °C to about 20 °C.

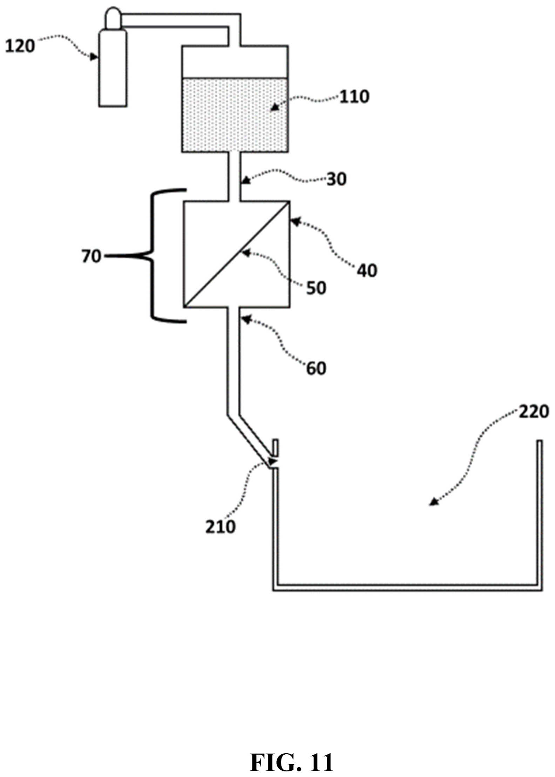

In some embodiments, isoporous block copolymer filtration membranes according to the present disclosure can be used to filter a gas or liquid during a wet etch and clean process (FIGS. 11 - 13). In at least one embodiment, the isoporous block copolymer filtration membranes can be used to filter a gas during a wet etch and clean process. In at least one embodiment, the isoporous block copolymer filtration membranes can be used to filter a liquid during a wet etch and clean process. In at least one embodiment, the isoporous block copolymer filtration membranes can be used to filter an organic liquid during a wet etch and clean process. In at least one embodiment, the isoporous block copolymer filtration membranes can be used to filter an aqueous liquid during a wet etch and clean process. In at least one embodiment, the isoporous block copolymer filtration membranes can be used to filter an aqueous liquid, wherein the liquid comprises a strong base, during a wet etch and clean process. In at least one embodiment, the isoporous block copolymer filtration membranes can be used to filter an aqueous liquid, wherein the liquid comprises a dilute base, during a wet etch and clean process. In at least one embodiment, the isoporous block copolymer filtration membranes can be used to filter an aqueous liquid, wherein the liquid comprises a strong acid, during a wet etch and clean process. In at least one embodiment, the isoporous block copolymer filtration membranes can be used to filter an aqueous liquid, wherein the liquid comprises a dilute acid, during a wet etch and clean process. In at least one embodiment, the isoporous block copolymer filtration membranes can be used to filter a non-aqueous liquid, wherein the liquid comprises an organic solvent, during a wet etch and clean process.

In at least one embodiment, the isoporous block copolymer filtration membranes can be used to filter a liquid during a wet etch and clean process, wherein the liquid is at an elevated temperature, for example around 75-80 °C. In at least one embodiment, the isoporous block copolymer filtration membranes can be used to filter a liquid during a wet etch and clean process, wherein the liquid is at an elevated temperature, for example around 80-100 °C. In at least one embodiment, the isoporous block copolymer filtration membranes can be used to filter a liquid during a wet etch and clean process, wherein the liquid is at an elevated temperature, for example around 100-105 °C. In at least one embodiment, the isoporous block copolymer filtration membranes can be used to filter a liquid during a wet etch and clean process, wherein the liquid is at an elevated temperature, for example around 105-175 °C. In at least one embodiment, the isoporous block copolymer filtration membranes can be used to filter a liquid during a wet etch and clean process, wherein the liquid is at an elevated temperature, for example around 175-180 °C. In at least one embodiment, the isoporous block copolymer filtration membranes can be used to filter a liquid during a wet etch and clean process, wherein the liquid is at an elevated temperature, for example around 180-190 °C. In at least one embodiment, the isoporous block copolymer filtration membranes can be used to filter a liquid during a wet etch and clean process, wherein the liquid is at an elevated temperature, for example around 190-200 °C.

In at least one embodiment, isoporous block copolymer filtration membranes according to the present disclosure can be used to filter a liquid or gas in the production of semiconductor electronics.

In at least one embodiment, isoporous block copolymer filtration membranes according to the present disclosure can be used to filter a liquid or gas in the production of data storage materials.

In at least one embodiment, isoporous block copolymer filtration membranes according to the present disclosure can be used to filter a liquid or gas in the production of electronic displays.

In at least one embodiment, isoporous block copolymer filtration membranes according to the present disclosure can be used to filter a liquid or gas in the production of flexible electronics.

In at least one embodiment, isoporous block copolymer filtration membranes according to the present disclosure can be used to filter a liquid or gas in the production of nanoparticles.

In at least one embodiment, isoporous block copolymer filtration membranes according to the present disclosure can be used to filter a liquid or gas in the production of microfluidics.

In at least one embodiment, isoporous block copolymer filtration membranes according to the present disclosure can be used to filter a liquid or gas in the production of solid-state lighting.

In at least one embodiment, isoporous block copolymer filtration membranes according to the present disclosure can be used to filter a liquid or gas in the production of photovoltaics.

In at least one embodiment, isoporous block copolymer filtration membranes according to the present disclosure can be used to filter air as a facilities-integrated cleanroom filter in a cleanroom facility.

In at least one embodiment, isoporous block copolymer filtration membranes according to the present disclosure can be used to filter liquids during wafer dicing in the production of semiconductor electronics.

In at least one embodiment, isoporous block copolymer filtration membranes according to the present disclosure can be used to filter a liquid during a wet etch and clean process, wherein the liquid is at ambient temperature, for example around 20-25 °C. Some examples of chemicals and solutions that may be filtered for wet etch and clean processes include: water; ammonium hydroxide; hydrofluoric acid; trimethylammonium hydroxide; ammonium fluoride; chelating agents; anionic surfactants such as alkyl sulfates, alkyl bicarboxylates, aryl sulfates, alkoxy bisulfates, and alkyl polyacrylic acids; nonionic surfactants such as alkylphenoxypolyethylene oxide alcohols, alkylphenoxy polyglycidols, acetylenic alcohols; zwitterionic surfactants such as betaines, sultaines, phosphatidylserine, and sphingomyelins; hydrocarbon surfactants; fluorocarbon surfactants such as fluorinated alkyl sulfonates; cationic surfactants such as alkyl sulfonium halides, alkyl ammonium halides, alkyl quaternary ammonium halides, alkyl benzylalkonium halides, and alkyl phosphonium halides; sulfuric acid; hydrogen peroxide; phosphoric acid; nitric acid; and hydrochloric acid. These chemicals may be present in aqueous or nonaqueous solutions in various concentrations and mixtures.

In some embodiments, isoporous block copolymer filtration membranes according to the present disclosure can be used to filter liquids before and/or during a photolithography process (FIG. 8). In at least one embodiment, the various chemicals used during photolithography for cleaning, deposition, development, etching are filtered by a isoporous block copolymer filtration membrane prior to any process step. In some embodiments, the isoporous block copolymer filtration membranes can be used to filter an aqueous liquid, for example water, during a photolithography process. In at least one embodiment, isoporous block copolymer filtration membranes can be used to filter a non-aqueous liquid, wherein the liquid comprises an organic solvent, during a photolithography process. In at least one embodiment, isoporous block copolymer filtration membranes can be used to filter a mixture ofliquids, for example water mixed with one or more organic solvents, during a photolithography process. In at least one embodiment, isoporous block copolymer filtration membranes can be used to filter a mixture of liquids, for example two or more organic solvents, during a photolithography process. Some examples of chemicals that may be filtered by an isoporous block copolymer filtration membrane include for example: alcohols such as ethanol, methanol, isopropanol, butanol, hexanol, heptanol, octanol, decanol, benzyl alcohol; amides such as N,N-dimethylacetamide, N,N-dimethylformamide, N- methyl-2-pyrrolidone; amines such as piperidine, morpholine, pyridine, diethylenetriamine, pyrrolidone; ethers such as methoxyethane, tetrahydrofuran, dioxane, dimethoxyethane; esters such as n-butyl acetate, methyl acetate, ethyl acetate, propyl acetate, pentyl acetate, amyl acetate, propylene glycol monomethyl ether acetate, methyl formate, ethyl formate, propyl formate, butyl formate, ethyl lactate, propyl lactate; glycols such as ethylene glycol, propylene glycol, triethylene glycol; glycol ethers such as ethylene glycol monomethyl ether, propylene glycol monomethyl ether, triethylene glycol monomethyl ether; halocarbons such as chloroform; hydrocarbons such as hexane, decane, octane, cyclohexane, pentane, toluene, xylene, benzene; ketones such as methyl ethyl ketone, octanone, nonanone, acetone, heptanone, hexanone, diisobutyl ketone phenylacetone, cyclohexanone, acetylacetone, propylene carbonate; nitriles such as acetonitrile; sulfones such as sulfolane; sulfoxides such as dimethylsulfoxide.

In some embodiments, isoporous block copolymer filtration membranes can be used to filter slurries during a chemical mechanical planarization process (FIG. 7). In at least one embodiment, isoporous block copolymer filtration membranes can be used to filter a slurry in bulk for a chemical mechanical planarization process. In at least one embodiment, isoporous block copolymer filtration membranes can be used to filter a slurry as point of use during a chemical mechanical planarization process. Some examples of chemicals, materials, and solutions that may be in a slurry and filtered for chemical mechanical planarization processes include: water; bases such as sodium hydroxide, potassium hydroxide, polyethyleneimine, ammoma, tetramethylammonium hydroxide, or ammonium hydroxide; acids such as nitric acid, hydrochloric acid, chloroacetic acid, sulfuric acid, succinic acid, citric acid, acetic acid, para-toluene sulfonic acid, benzenesulfonic acid and sulfonic acid; colloidal oxides such as alumina, ceria, silica, titania, zirconia; nonionic surfactants such as alkylphenoxypolyethylene oxide alcohols, alkylphenoxy polyglycidols, acetylenic alcohols, propylene glycol, polyethylene glycol alkyl ethers, ethoxylated alcohols, polyethylene glycol octylphenyl ethers, glycerol alkyl esters, sorbitan alkyl esters, polyethylene glycol copolymers; fluorinated surfactants such as fluorinated alkyl sulfonates; zwitterionic surfactants such as betaines, sultaines, phosphatidylserine, and sphingomyelins; anionic surfactants such as alkyl sulfates, alkyl bicarboxylates, aryl sulfates, alkoxy bisulfates, and alkyl polyacrylic acids; cationic surfactants such as alkyl sulphonium halides, alkyl ammonium halides, alkyl quaternary ammonium halides, alkyl benzylalkonium halides, and alkyl phosphonium halides; corrosion inhibiters such as benzotriazole, triazole, pyrazole, imidazole, and benzimidazole; and oxidizing agents such as percarbonates, hydrogen peroxide, peroxyacids, permanganates, periodic acid, and nitric acid.

In some embodiments, isoporous block copolymer filtration membranes can used to filter water for ultrapure water (FIGS. 9 and 10). In at least one embodiment, isoporous block copolymer filtration membranes can be used to filter water for ultrapure water wherein the filtration membrane is incorporated into production facilities, i.e. permanent plumbing. In at least one embodiment, isoporous block copolymer filtration membranes can be used to filter water for ultrapure water wherein the filtration membrane is located at or near a point of use, i.e. on a production instrument where the ultrapure water is dispensed.

In some embodiments, the feed is a liquid and a pressure differential across an isoporous block copolymer filtration membrane is induced by gas pressurizing the feed (FIGS. 1, 4, 6, 11, 14). In some embodiments, the feed is a liquid and a pressure differential across an isoporous block copolymer filtration membrane is induced by a pump pressurizing the feed (FIGS. 2, 3, 5, 7, 8, 12, 13). In some embodiments, the feed is a gas and a pressure differential across an isoporous block copolymer filtration membrane is induced by a pressurized source, e.g. a pressurized gas cylinder. In some embodiments, the feed is a gas and a pressure differential across an isoporous block copolymer filtration membrane is induced by a fan. In some embodiments, the feed is water and a pressure differential is induced by a pressurized source, e.g. a building water inlet (FIGS. 9 and 10). In some embodiments, the differential pressure across an isoporous block copolymer filtration membrane is constant. In some embodiments, the differential pressure across an isoporous block copolymer filtration membrane is variable, for example, the pressure differential is increased during the process. In some embodiments, the differential pressure across an isoporous block copolymer filtration membrane is from around 1 bar to around 20 bar. In at least one embodiment, the differential pressure across an isoporous block copolymer filtration membrane is from around 1 bar to around 10 bar. In at least one embodiment, the differential pressure across an isoporous block copolymer filtration membrane is from around 1 bar to around 7 bar. In at least one embodiment, the differential pressure across an isoporous block copolymer filtration membrane is around 1 bar. In at least one embodiment, the differential pressure across an isoporous block copolymer filtration membrane is around 2 bar. In at least one embodiment, the differential pressure across an isoporous block copolymer filtration membrane is around 3 bar. In at least one embodiment, the differential pressure across an isoporous block copolymer filtration membrane is around 4 bar. In at least one embodiment, the differential pressure across an isoporous block copolymer filtration membrane is around 5 bar. In at least one embodiment, the differential pressure across an isoporous block copolymer filtration membrane is around 6 bar. In at least one embodiment, the differential pressure across an isoporous block copolymer filtration membrane is around 7 bar. In at least one embodiment, the differential pressure across an isoporous block copolymer filtration membrane is around 10 bar.

In various embodiments, the flux of the filtration membranes may be different depending on the filter pore size, solute removal rating, feed chemical composition, pressure differential of the process, etc. In at least one embodiment, the flux of a filtration membrane in a liquid filtration process is between around 80 LMH/bar (liters/m²/h/bar) to around 3000 LMH/bar. In at least one embodiment, the flux of a filtration membrane in a liquid filtration process is between around 80 LMH/bar to around 100 LMH/bar. In at least one embodiment, the flux of a filtration membrane in a liquid filtration process is between around 100 LMH/bar to around 300 LMH/bar. In at least one embodiment, the flux of a filtration membrane in a liquid filtration process is between around 100 LMH/bar to around 200 LMH/bar. In at least one embodiment, the flux of a filtration membrane in a liquid filtration process is between around 200 LMH/bar to around 1000 LMH/bar. In at least one embodiment, the flux of a filtration membrane in a liquid filtration process is between around 1000 LMH/bar to around 3000 LMH/bar. In at least one embodiment, the flux of a filtration membrane in a liquid filtration process is between around 1000 LMH/bar to around 2000 LMH/bar. It is noted that flux characteristics rely on a number of factors, including temperature, pressure, feedstream composition and purity, filtration membrane pore diameter, filter assembly configuration, etc.

The retention rating of filtration membranes can be defined as a rejection percentage, e.g. 100 x (concentration of solute in permeate)/(concentration of solute in feed). This can alternatively be expressed as a log removal value (LRV) of a solute, e.g. 1 LRV = 90% rejection of solute = 1 log removal value, 2 LRV = 99% rejection of solute, 3 LRV = 99.9% rejection of solute, etc. In some embodiments the retention rating of an isoporous block copolymer filtration membrane in a filter assembly for the separation is between around 90% rejection (1 LRV) to 99.99999999% rejection (10 LRV). In at least one embodiment, the retention rating of an isoporous block copolymer filtration membrane in a filter assembly for the separation is between around 90% rejection (1 LRV) to 99.9% rejection (3 LRV). In at least one embodiment, the retention rating of an isoporous block copolymer filtration membrane in a filter assembly for the separation is between around 90% rejection (1 LRV) to 99.9% rejection (3 LRV). In at least one embodiment, the retention rating of an isoporous block copolymer filtration membrane in a filter assembly for the separation is between around 99.9% rejection (3 LRV) to 99.9999% rejection (6 LRV). In at least one embodiment, the retention rating of an isoporous block copolymer filtration membrane in a filtration assembly for the separation is between around 99.9999% rejection (6 LRV) to 99.99999999% rejection (10 LRV). It is noted that rejection characteristics rely on a number of factors, including temperature, pressure, feedstream composition and purity, filtration membrane pore diameter, filter assembly configuration, etc.

Each of FIGS. 1-14 show one or more the following elements: an air source 10, a fan 20, a filter assembly inlet 30, a filter assembly housing 40, an isoporous block copolymer film 50, a filter outlet 60, a filter assembly 70, a filter assembly retentate outlet 80, a filter assembly vent 90, a pump 100, a liquid feed source 110, a compressed gas cylinder 120, a collection/storage vessel 130, a slurry feed 135, a slurry dispensing outlet 140, a rotating wafer holder 150, a wafer 160, a rotating polishing pad 170, a liquid sprayer outlet 180, a pressurized water feed 190, a faucet/dispenser 200, a bath fill 210, a liquid bath 220, a bath drain 230, a bath recirculation fill 240, and an outlet valve 250. Features presented in the figures may exist in various configurations within the same or different embodiments. For example, the air source 10 may vary in purity, pressure, composition, etc.; the fan 20 may vary in material, power, size, air flux, etc.; a filter inlet 30 may vary in material, diameter, location, etc.; the filter housing 40 may vary in material, size, shape, etc.; the isoporous block copolymer filtration membrane materials 50 may vary in composition, polymer size, number of polymer blocks, number of layers, pore size, surface chemistry, chemical compatibility, thermal compatibility, hydrophilicity, thickness, flux, etc.; the filter outlet 60 may vary in material, diameter, location, etc.; the filter assembly 70 may vary in material, size, shape, number of filter layers, etc.; the filter retentate outlet 80 may vary in material, diameter, location, etc.; the filter vent 90 may vary in material, diameter, location, etc.; the pump 100 may vary in material, type, size, power, liquid compatibility, etc.; the liquid feed 110 may vary in chemical composition, concentration, temperature, purity, viscosity, density, etc.; the compressed gas cylinder 120 may vary in the gas stored in it, size, pressure, material, etc.; the collection/storage vessel 130 may vary in material, size, pressure rating, configuration, etc.; the slurry feed 135 may vary in chemical composition, concentration, temperature, purity, viscosity, density, etc.; the slurry dispensing outlet 140 may vary in material, diameter, location, etc.; the liquid sprayer outlet 180 may vary in material, diameter, location, liquid velocity rating, etc.; the pressurized water feed 190 may vary in pressure, configuration, pressure, water source, etc.; the faucet/dispenser 200 may vary in material, diameter, location, liquid velocity rating, etc.; the bath fill 210 may vary in material, diameter, location, liquid velocity rating, etc.; the liquid bath 220 may vary in material, size, configuration, etc.; the bath drain 230 may vary in in material, diameter, location, etc.; the bath recirculation fill 240 may vary in in material, diameter, location, etc.; and the outlet valve 250 may vary in in material, diameter, location, etc.

### Examples

**Example** 1. In this example, a wet etch clean bath filtration and recirculation process is performed (see FIG. 12). The feed composition to be filtered is an aqueous solution comprising 30 vol¾ hydrogen peroxide and 30 vol¾ ammonia. The filtration assembly will be in the shape of a capsule and be operated in a normal flow, in-line, configuration where the feed enters the filtration assembly from a liquid bath and the filtered product reenters the bath via a recirculation fill. The filtration assembly will include a single layer isoporous block copolymer filtration membrane that is hydrophilic, thermally stable, chemically resistant to alkalines and oxidizers, has an average pore size of about 10 nm and a flux of about 1500 LMH/bar. The most selective side of the membrane will face a feed inlet from the liquid bath. The filtration process is performed at 80 °C with a partial pressure of about 2 bar applied across the filtration membrane. The filtration membrane will remove particulates having diameters of about 10 nm or greater with an LRV of about 3.

**Example 2.** In this example, a wet etch clean bath filtration and recirculation process is performed (see FIG. 12). The feed composition to be filtered is an aqueous solution comprising 2 vol% hydrofluoric acid. The filtration assembly will be in the shape of a capsule and be operated in a normal flow, in-line, configuration where the feed enters the filtration assembly from a liquid bath and the filtered product reenters the bath via a recirculation fill. The filtration assembly will include a single layer isoporous block copolymer filtration membrane that is chemically resistant to acids, has an average pore size of about 20 nm and a flux of about 2000 LMH/bar. The most selective side of the membrane will face a feed inlet from the liquid bath. The filtration process is performed at 25 °C with a partial pressure of about 2 bar applied across the filtration membrane. The filtration membrane will remove particulates having diameters of about 20 nm or greater with an LRV of about 4.

Example 3. In this example, a photolithography solvent filtration is performed (see FIG. 8). The feed composition to be filtered is propylene glycol methyl ether acetate (PGMEA). The filtration assembly will be in the shape of a capsule and be operated in a normal flow, in-line, configuration where the feed enters the filtration assembly from a liquid feed source and the filtered product exits the filtration assembly to a liquid sprayer outlet via a filter assembly outlet. The filtration assembly will include a single layer isoporous block copolymer filtration membrane that is chemically resistant to solvents, has an average pore size of about 15 nm and a flux of about 300 LMH/bar. The most selective side of the membrane will face a feed inlet from the liquid feed source. The filtration process is performed at 25 °C with a partial pressure of about 2 bar applied across the filtration membrane. The filtration membrane will remove particulates, in the form of polymer particles and gels, having diameters of about 20 nm or greater with an LRV of about 4.

Example 4. In this example, a bulk filtration is performed (see FIGS. 6 and 9). The feed composition to be filtered is isopropanol. The filtration assembly will be in the shape of a capsule and be operated in a normal flow, in-line, configuration where the feed enters the filtration assembly from a liquid feed source and the filtered product exits the filtration assembly to a storage vessel via a filter assembly outlet. The filtration assembly will include a single layer isoporous block copolymer filtration membrane that is hydrophilic and chemically resistant to solvents, has an average pore size of about 15 nm and a flux of about 600 LMH/bar. The most selective side of the membrane will face a feed inlet from the liquid feed source. The filtration process is performed at 25 °C with a partial pressure of about 4 bar applied across the filtration membrane. The filtration membrane will remove particulates having diameters of about 20 nm or greater with an LRV of about 6.

**Example** 5. In this example, a photolithography solvent filtration is performed (see FIG. 8). The feed composition to be filtered is a mixture of ethyl acetate and n-butyl acetate. The filtration assembly will be in the shape of a capsule and be operated in a normal flow, in-line, configuration where the feed enters the filtration assembly from a liquid feed source and the filtered product exits the filtration assembly to a liquid sprayer outlet via a filter assembly outlet. The filtration assembly will include a single layer isoporous block copolymer filtration membrane that is chemically resistant to solvents, has an average pore size of about 15 nm and a flux of about 150 LMH/bar. The most selective side of the membrane will face a feed inlet from the liquid feed source. The filtration process is performed at 25 °C with a partial pressure of about 2 bar applied across the filtration membrane. The filtration membrane will remove particulates, including polymer particles and gels, having diameters of about 15 nm or greater with an LRV of about 4.

**Example** 6. In this example, a chemical mechanical planarization slurry filtration is performed (see FIG. 7). The feed composition to be filtered is an aqueous slurry with inorganic abrasives and a base. A point of use filtration assembly will be used and be operated in a normal flow configuration where the feed enters the filtration assembly from a slurry feed source and the filtered product exits the filtration assembly to a slurry dispensing outlet via a filter assembly outlet. The filtration assembly will include a single layer isoporous block copolymer filtration membrane that is chemically resistant to bases, has an average pore size of about 15 nm and a flux of about 80 LMH/bar. The most selective side of the membrane will face a filter assembly outlet. The filtration process is performed at 25 °C with a partial pressure of about 4 bar applied across the filtration membrane. The filtration membrane will remove particulates, having diameters of about I00 nm or greater with an LRV of about 2.

**Example** 7. In this example, an ultrapure water generation/filtration is performed (see FIGS. 9 and 10). The feed composition to be filtered is water. The filtration assembly will be in the shape of a capsule and be operated in a normal flow, in-line, configuration where the feed enters the filtration assembly from a liquid feed source and the filtered product exits the filtration assembly to either 1) a storage vessel or 2) a faucet/dispenser via a filter assembly outlet. The filtration assembly will include a single layer isoporous block copolymer filtration membrane that is hydrophilic, has an average pore size of about 5 nm and a flux of about 3000 LMH/bar. The most selective side of the membrane will face a filter assembly inlet. The filtration process is performed at 25 °C with a partial pressure of about 4 bar applied across the filtration membrane. The filtration membrane will remove particulates, having diameters of about 5nm or greater with an LRV of about 5.

**Example 8.** In this example, a bulk filtration is performed (see FIGS. 6 and 9). The feed composition to be filtered is isopropanol. A point of use filtration assembly will be used and be operated in a cross-flow configuration, using crossflow-filter housing cartridges, where the feed enters the filtration assembly from a liquid feed source and the filtered product exits the filtration assembly to a storage vessel via a filter assembly outlet. The filtration assembly will include a single layer isoporous block copolymer filtration membrane that is hydrophilic and chemically resistant to solvents, has an average pore size of about 5 nm and a flux of about 200 LMH/bar. The most selective side of the membrane will face a feed inlet from the liquid feed source. The filtration process is performed at 25 °C with a partial pressure of about 2 bar applied across the filtration membrane. The filtration membrane will remove particulates having diameters of about 5 nm or greater with an LRV of about 4.

**Example 9.** In this example, a photolithography solvent filtration is performed (see FIG. 8). The feed composition to be filtered is N-methylpyrrolidone (NMP). The filtration assembly will be in the shape of a capsule and be operated in a normal flow, in-line, configuration where the feed enters the filtration assembly from a liquid feed source and the filtered product exits the filtration assembly to a liquid sprayer outlet via a filter assembly outlet. The filtration assembly will include two layers of isoporous block copolymer filtration membrane that is chemically resistant to solvents, has an average pore size of about 10 nm and a flux of about 100 LMH/bar. The most selective side of the membrane will face a filter assembly outlet. The filtration process is performed at 25 °C with a partial pressure of about 4 bar applied across the filtration membrane. The filtration membrane will remove particulates, including polymer particles and gels, having diameters of about 10 nm or greater with an LRV of about 8.

**Example 10.** In this example, a gas filtration is performed (see FIGS. 6 and 9). The feed composition to be filtered is argon gas. The filtration assembly will be in the shape of a capsule and be operated in a normal flow, in-line, configuration where the feed enters the filtration assembly from a compressed gas feed source and the filtered product exits the filtration assembly to a containment vessel or downstream use condition via a filter assembly outlet. The filtration assembly will include a single layer isoporous block copolymer filtration membrane that has an average pore size of about 100 nm. The most selective side of the membrane will face a feed inlet from the compressed gas feed source. The filtration process is performed at 25 °C with a partial pressure of about 7 bar applied across the filtration membrane. The filtration membrane will remove particulates having diameters of about 100 nm or greater with an LRV of about 6.

In a first embodiment there may be provided a method of filtering a feed comprising a liquid for or during the production of electronics, comprising filtering said feed using at least one filter assembly, wherein said at least one filter assembly comprises at least one isoporous block copolymer filtration membrane.

Suitably in the method of the first embodiment the liquid is water, for use as ultrapure water.

Suitably in the method of the first embodiment the liquid is an aqueous solution.

Suitably in the method of the first embodiment the liquid is a non-aqueous solution, the non-aqueous solution comprising at least one organic solvent.

Suitably in the method of the first embodiment the liquid is used in a wet etch and clean step of electronics production.

Suitably in the method of the first embodiment the liquid is used in a photolithographic step of electronics production.

Suitably in the method of the first embodiment the liquid is sprayed onto a wafer for said photolithography step.

Suitably in the method of the first embodiment the feed is a slurry comprising a solid, and said slurry is used in a chemical mechanical planarization step of electronics production. Suitably said slurry is dispensed onto a polishing pad for said chemical mechanical planarization step.

Suitably in the method of the first embodiment the filter assembly is operated in a normal flow configuration.

Suitably in the method of the first embodiment the filter assembly is operated in a crossflow configuration

Suitably in the method of the first embodiment the filter assembly comprises a filter inlet, an isoporous block copolymer filter, a filter outlet, optionally a vent, and optionally a retentate outlet.

Suitably in the method of the first embodiment the liquid is filled into a bath for said wet etch and clean step.

Suitably in the method of the first embodiment a pressure differential across the filter assembly is induced by a pump.

Suitably in the method of the first embodiment a pressure differential across the filter assembly is induced by a compressed gas.

Suitably in the method of the first embodiment a pressure differential across the filter assembly is induced by a pressurized water source.

Suitably in the method of the first embodiment the isoporous block copolymer filter comprises pores having diameters in the range of about 5 nm to about 100 nm.

In a second embodiment there may be provided a method of filtering a feed comprising a gas for or during the production of electronics comprising filtering said gas using at least one filter assembly, wherein said at least one filter assembly comprises at least one isoporous block copolymer filtration membrane.

Suitably in the method of the second embodiment the the gas is air.

In a third embodiment there may be provided a method of filtering a feed comprising a liquid for or during the production of nanosystems, comprising filtering said feed using at least one filter assembly, wherein said at least one filter assembly comprises at least one isoporous block copolymer filtration membrane.

## Claims

1. A method of filtering a feed comprising a liquid for or during the production of electronics, the method comprising filtering said feed using at least one filter assembly, wherein said at least one filter assembly comprises at least one isoporous block copolymer filtration membrane;
wherein the isoporous block copolymer filtration membrane comprises a multiblock copolymer having a hydrogen-bonding block and one or more hydrophobic blocks, wherein at least one of the one or more hydrophobic blocks is a low glass transition temperature (T_{g}) block.

2. The method according to claim 1, wherein the multiblock copolymer is poly(isoprene-b-styrene-b-4-vinylpyridine).

3. The method according to claim 1, wherein the multiblock copolymer is selected from the group consisting of poly(isoprene-b-styrene-b-4-vinylpyridine), poly(isoprene)-b- poly(styrene)-b-poly((4-vinyl)pyridine), poly(isoprene)-b-poly(styrene)-b-poly((2 -vinyl) pyridine), poly(isoprene)-b-poly(styrene)-b-poly(ethylene oxide), poly(isoprene)-b-poly(styrene)- b-poly(methyl methacrylate), poly(isoprene)-b-poly(styrene)-b-poly(acrylic acid), poly(isoprene)-b-poly(styrene)-b-poly(dimethylethyl amino ethyl methacrylate), poly(isoprene)-b-poly(styrene)-b-poly(hydroxystyrene), poly(isoprene)-b-poly(α-methyl styrene)-b-poly((4-vinyl)pyridine), poly(isoprene)-b-poly(α-methyl styrene)-b-poly((2-vinyl) pyridine), poly(isoprene)-b-poly(α-methyl styrene)-b-poly(ethylene oxide), poly(isoprene)-b-poly(α-methyl styrene)-b-poly(methyl methacrylate), poly(isoprene)-b-poly(α-methyl styrene)-b-poly(acrylic acid), poly(isoprene)-b-poly(α-methyl styrene)-b-poly(dimethylethyl amino ethyl methacrylate), poly(butadiene)-b-poly(styrene)-b-poly((4-vinyl)pyridine), poly(butadiene)-b-poly(styrene)-b-poly((2-vinyl) pyridine), poly(butadiene)-b-poly(styrene)-b-poly(ethylene oxide), poly(butadiene)-b- poly(styrene)-b-poly(methyl methacrylate), poly(butadiene)-b-poly(styrene)-b-poly(acrylic acid), poly(butadiene)-b-poly(styrene)-b-poly(dimethylethyl amino ethyl methacrylate), poly(butadiene)-b-poly(styrene)-b-poly(hydroxystyrene), poly(butadiene)-b-poly(α-methyl styrene)-b-poly((4-vinyl)pyridine), poly(butadiene)-b-poly(α-methyl styrene)-b-poly((2 -vinyl) pyridine), poly(butadiene)-b-poly(α-methyl styrene)-b-poly(ethylene oxide), poly(butadiene)-b- poly(α-methyl styrene)-b-poly(methyl methacrylate), poly(butadiene)-b-poly(α-methyl styrene)- b-poly(acrylic acid), poly(butadiene)-b-poly(α-methyl styrene)-b-poly(dimethylethyl amino ethyl methacrylate), and poly(butadiene)-b-poly(styrene)-b-poly(hydroxystyrene).

4. The method according to claim 1, wherein the hydrogen-bonding block is selected from the group consisting of poly((4-vinyl)pyridine), poly((2-vinyl) pyridine), polyethylene oxide), poly(methacrylates) such as poly(methacrylate), poly(methyl methacrylate), and poly(dimethylethyl amino ethyl methacrylate), poly(acrylic acid), and poly(hydroxystyrene).

5. The method according to claim 1, wherein the hydrogen-bonding block is poly((4-vinyl)pyridine).

6. The method according to any one of claims 1 and 4-5, wherein the one or more hydrophobic blocks are each independently selected from the group consisting of poly(styrene), poly(alphamethyl styrene), polyethylene, polypropylene, polyvinyl chloride, and polytetrafluoroethylene.

7. The method according to any one of claims 1 and 4-5, wherein low glass transition temperature (T_{g}) block is selected from the group consisting of poly(isoprene), poly(butadiene), poly(butylene), and poly(isobutylene).

8. The method according to claim 1, wherein the multipblock copolymer comprises a low T_{g} polymer block, a poly(styrene) block, and a poly((4-vinyl) pyridine) block.

9. The method according to any one of claims 1-8, wherein the isoporous multiblock copolymer filtration membrane comprises mesopores having a mesopore size diameter of from about 5 nm to about 50 nm.

10. The method according to claim 1, wherein the liquid comprises propylene glycol methyl ether acetate (PGMEA) for use as a photolithography solvent;
wherein the filtration is performed at about 25 °C with a partial pressure of about 2 bar applied across the filtration membrane; and
wherein the membrane removes particulates having diameters of about 20 nm or greater with an LRV of about 4.

11. The method according to claim 1, wherein the liquid comprises one or both of ethyl acetate and n-butyl acetate for use as a photolithography solvent;
wherein the filtration is performed at about 25 °C with a partial pressure of about 2 bar applied across the filtration membrane; and
wherein the membrane removes particulates having diameters of about 15 nm or greater with an LRV of about 4.

12. The method according to claim 1, wherein the liquid comprises N-methylpyrrolidone (NMP) for use as a photolithography solvent;
wherein the filtration is performed at about 25 °C with a partial pressure of about 4 bar applied across the filtration membrane; and
wherein the membrane removes particulates having diameters of about 10 nm or greater with an LRV of about 8.

13. The method of claim 1 wherein the liquid comprises one or more organic solvents used in a photolithographic step of electronics production.
